# EUROPÄISCHE PATENTSCHRIFT

(11) **EP 0 499 695 B1**
(45) Veröffentlichungstag und Bekanntmachung des Hinweises auf die Patenterteilung: **01.05.1996**
(21) Anmeldenummer: 91119483.5
(22) Anmeldetag: 14.11.1991
(51) Int. Cl.: G05B 19/045

(54) **Speicherprogrammierbare Steuerung**
Programmable logic controller
Automate logique programmable

(30) Priorität: 22.02.1991 DE 4105678
(43) Veröffentlichungstag der Anmeldung: 26.08.1992
(60) Teilanmeldung: 94116917.9
(73) Patentinhaber: SIEMENS AKTIENGESELLSCHAFT, D-80333 München (DE)
(72) Erfinder: Bock, Günther, Dipl.-Ing., W-8457 Kümmersbruck (DE); Wombacher, Christof, Dipl.-Ing. (FH), W-8450 Amberg (DE); Lengemann, Andre, Dipl.-Ing. (FH), W-8459 Edelsfeld (DE); Macht, Helmut, Dipl.-Ing., W-8457 Kümmersbruck (DE); Prechtl, Manfred, Dipl.-Ing., W-8470 Nabburg (DE)

(56) Entgegenhaltungen:
- EP-A- 0 071 703
- EP-A- 0 266 065
- EP-A- 0 285 814
- EP-A- 0 338 077
- EP-A- 0 380 456
- EP-A- 0 489 228
- WO-A-84/02988
- DE-A- 2 217 465
- DE-A- 3 125 722
- DE-A- 3 303 826
- DE-A- 3 513 677
- GB-A- 1 598 499
- PATENT ABSTRACTS OF JAPAN,vol. 8, Number 60 (P-262)[1497] March 22, 1984, & JP-A-58-211207, 8.12.1983
- P. Wratil "Speicherprogrammierbare Steuerung in der Automatisierungstechnik", 1. Auflage 1989, Vogel Verlag, Würzburg, Seiten 78, 79
- U. TIETZE, CH. SCHENK "Halbleiter-Schaltungstechnik", März 1990, Springer-Verlag, Berlin, De, Seiten 306-310
- Electonic engineering, Vol. 52 (1980) Jan., No. 633, London, Gb, T.L. Larson:"Field-programmable logic devices", Seiten 37-54
- Electronics, Vol. 52, No. 14, 5. Juli 1979, Napoleone Cavlan:"Field-programmable arrays: powerfull alternative to random logic", Seiten 109-114

## Beschreibung

Die Erfindung betrifft eine speicherprogrammierbare Steuerung nach dem Oberbegriff des Anspruchs 1.

Früher wurden Maschinensteuerungen in Schutz-Technik aufgebaut. Schütz-Schaltungen arbeiten zwar parallel und sind daher schnell, sie sind jedoch störanfällig, kompliziert und nur umständlich aufzubauen bzw. anzupassen. Inzwischen sind speicherprogrammierbare Steuerungen weit verbreitet. Sie arbeiten sequentiell und sind erheblich einfacher aufgebaut und zu programmieren. Aber auch moderne speicherprogrammierbare Steuerungen sind wegen ihrer sequentiellen Arbeitsweise oftmals nicht schnell genug, z.B. für die Steuerung von Verpakkungs- oder Etikettiermaschinen. Steuerungen für diese Maschinen werden in der Regel auch heute noch auf der Basis zu verdrahtenderr Logikelemente aufgebaut. Dadurch bieten diese Steuerungen zwar eine hohe Verarbeitungsgeschwindigkeit, jedoch ist das Verdrahten der Logikelemente sehr umständlich und fehlerträchtig.

Aus dem Buch "Speicherprogrammierbare Steuerung in der Automatisierungstechnik" von P. Wratil, erschienen 1989 im Vogel Verlag, Würrzburg, Seiten 78 und 79, ist eine speicherprogrammierbare Steuerung bekannt, bei der jeder möglichen Eingangsinformation eine spezielle Adresse in einem ROM zugeordnet und die gewünschte Ausgangsinformation als Verknüpfungselement der ROM-Programmierung dargestellt wird. Dabei ist nachteilig, daß ein ROM sich nur als Ersatz für statische logische Kombinationen verwenden läßt, da Elemente wie z.B. Zähler oder Timer fehlen. Sequentielle Vorgänge wären höchstens durch Rückführung der Ausgänge des ROM an seine Eingänge realisierbar.

In der älteren Europäischen Anmeldung 91 113 356.9 ist ein Automatisierungsgerät mit einem programmierbaren Logikbaustein offenbart, wobei dem Logikbaustein Prozeßeingangsdaten zugeführt werden und der Logikbaustein Prozeßausgangsdaten liefert.

In Electronic engineering, Vol. 52 (1980) Jan., No. 633, Londen GB, T.L. Larson: "Field programmable logic devices", Seiten 37-54 sowie in Electronics, Vol. 52, No. 14, 5. Juli 1979, Napoleone Cavlan: "Field-programmable arrays: powerful alternative to ransom logic", Seiten 109-114 sind verschiedene umfeldprogrammierbare Logikfelder beschrieben.

Aus der EP 0 380 456 A2 und der EP 0 338 077 A1 ist bekannt, einfache umfeldprogrammierbare Logikfelder bei speicherprogrammierbaren Steuerungen einzusetzen.

Die Aufgabe der vorliegenden Erfindung besteht darin, eine speicherprogrammierbare Steuerung zu Verfügung zu stellen, mit der es möglich ist, auch komplexere logische Schaltungen, insbesondere auch Schaltungen mit Zählern, Merkern und/oder Timern, einfach zu realisieren.

Die Aufgabe wird dadurch gelöst, daß die gattungsgemäße speicherprogrammierbare Steuerung gemäß dem kennzeichnenden Teil des Anspruchs 1 ausgebildet ist.

Wenn die interne Verschaltung des umfeldprogrammierbaren Logikfeldes reprogrammierbar ist, ist die Steuerung leicht an geänderte Anforderungen anpaßbar.

Die Programmierung des umfeldprogrammierbaren Logikfeldes ist dabei besonders einfach, wenn es einen - vorzugsweise statischen - Speicher zum Speichern derr Bedingungen aufweist, die seine interne Verschaltung festlegen.

Wenn die Steuerung modular aufgebaut ist, ist das umfeldprogrammierbare Logikfeld vorteilhaft in einer Ein-/Ausgabe-Baugruppe angeordnet, weil dann der Systembus der Steuerung nicht für den Datentransfer benutzt werden muß. In diesem Fall ist es weiterhin von Vorteil, wenn das umfeldprogrammierbare Logikfeld direkt auf der Baugruppe programmiert werden kann, z.B. über eine Schnittstelle zum Anschluß eines Daten-Ein-/Ausgabegeräts, wobei die Schnittstelle direkt oder indirekt auf den Systembus oder aber auch auf das umfeldprogrammierbare Logikfeld selbst wirkt, oder über einen zusteckbaren Anwenderspeicher, der die interne Verschaltung des umfeldprogrammierbaren Logikfeldes festlegt.

Weitere Vorteile und Einzelheiten ergeben sich aus der nachfolgenden Beschreibung eines Ausführrungsbeispiels, anhand der Zeichnungen und in Verbindung mit den weiteren Unteransprüchen. Es zeigen:
- FIG 1: mehrere Baugruppen einer modular aufgebauten speicherprogrammierbaren Steuerung,
- FIG 2: den inneren Aufbau einer Ein-/Ausgabe-Baugruppe,
- FIG 3: die Verbindungen zwischen Ein- und Ausgängen,
- FIG 4: den konstruktiven Aufbau einer Ein-/Ausgabe-Baugruppe,
- FIG 5: die innere Struktur eines umfeldprogrammierbaren Logikfeldes,
- FIG 6: den Aufbau eines Logikblocks,
- FIG 7: eine beispielhaft zu lösende Problemstellung in Form einer Ampelanlage,
- FIG 8: die zugehörige schalttechnische Realisierung der Ampelanlagensteuerung,
- FIG 9: die Vorabfestlegung der internen elektrischen Verbindungen,
- FIG 10: ein Beispiel einer internen elektrischen Standard-Verbindung,
- FIG 11: die Realisierung des vorgegebenen Gesamtverhaltens im umfeldprogrammierbaren Logikfeld und
- FIG 12: schematisch die Kommunikation zwischen Logikbaustein und Prozessor.

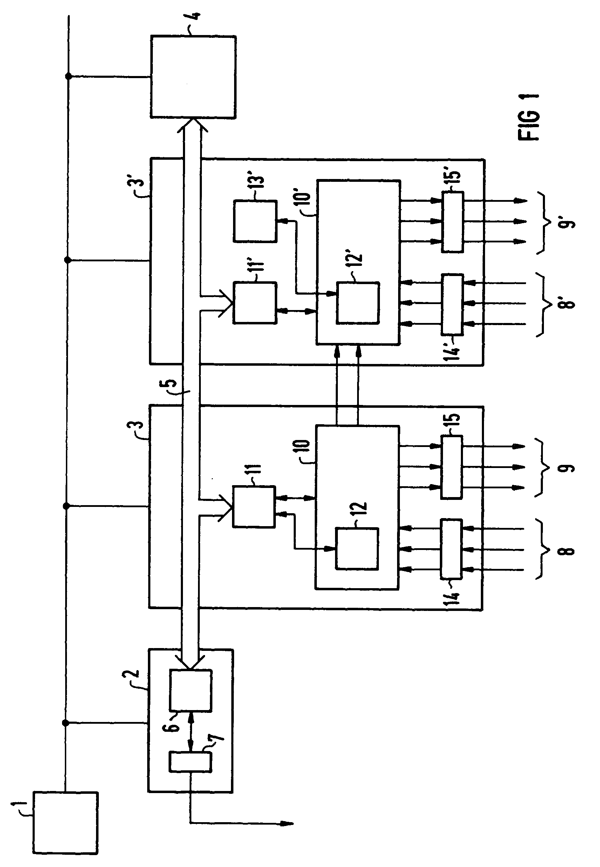

Gemäß FIG 1 besteht eine modular aufgebaute speicherprogrammierbare Steuerung aus einer Stromversorgung 1, einer Zentraleinheit 2, den Ein-/Ausgabe-Baugruppen 3, 3' sowie weiteren Peripherieeinheiten 4. Die Baugruppen 2, 3, 3', 4 sind dabei über einen Bus 5 miteinander verbunden. Die Zentraleinheit 2 weist mindestens einen Prozessor 6 zum Abarbeiten eines Programmes sowie eine Schnittstelle 7 zum Datenaustausch mit einem Programmiergerät auf.

Wie weiterhin aus FIG 1 ersichtlich ist, weist die Baugruppe 3 einen Logikbaustein 10 auf, der z.B. ein umfeldprogrammierbares Logikfeld (FPGA) sein kann. Der Logikbaustein 10 ist über den Prozessor 11 mit dem Bus 5 und damit auch mit der Zentraleinheit 2 verbunden. Dadurch ist es möglich, von einem Programmiergerät aus über die Zentraleinheit 2 die interne Verschaltung des Logikbausteins 10 derart zu programmieren, daß die Eingänge 8 über den Logikbaustein 10 gemäß zuvor aus dem abzuarbeitenden Programm abgeleiteten logischen Bedingungen zwischen Eingangs- und Ausgangssignalen mit den Ausgängen 9 verbunden sind. Der Anwender erstellt hierzu mit dem oben erwähnten Programmiergerät zwei Programmteile: Einen zeitunkritischen Teil und einen zeitkritischen Teil. Beide Teile werden vom Programmiergerät an den Prozessor 6 der Zentraleinheit 2 übertragen. Der zeitunkritische Teil wird in der Zentraleinheit 2 abgespeichert und, wie bei speicherprogrammierbaren Steuerungen allgemein üblich, sequentiell abgearbeitet. Der zeitkritische Teil wird vom Prozessor 6 weiter an die Logikbausteine 10, 10' übertragen und von diesen in eine logische Verschaltung umgesetzt.

Die beiden Programmteile sind völlig unabhängig voneinander. Es ist jedoch über Sonderbefehle möglich, daß der Prozessor 6 und die Logikbausteine 10, 10' Informationen austauschen.

Mit Vorteil werden dabei die logischen Bedingungen, die die Verschaltung des Logikbausteins 10 festlegen, in einen statischen Speicher 12 des Logikbausteins 10 übertragen und die Verschaltung des Logikbausteins 10 aufgrund des Inhalts des Speichers 12 bestimmt.

Die Baugruppe 3' weist ebenfalls einen Logikbaustein 10' mit einem statischen Speicher 12' auf, der Logikbaustein 10' wird jedoch über einen Anwenderspeicher 13' programmiert. Wenn die Verschaltung des Logikbausteins 10' geändert werden soll, muß der Anwenderspeicher 13' ausgetauscht bzw. umprogrammiert werden, da die logischen Bedingungen, die die Verschaltung des Logikbausteins 10' bestimmen, im Anwenderspeicher 13' abgespeichert sind.

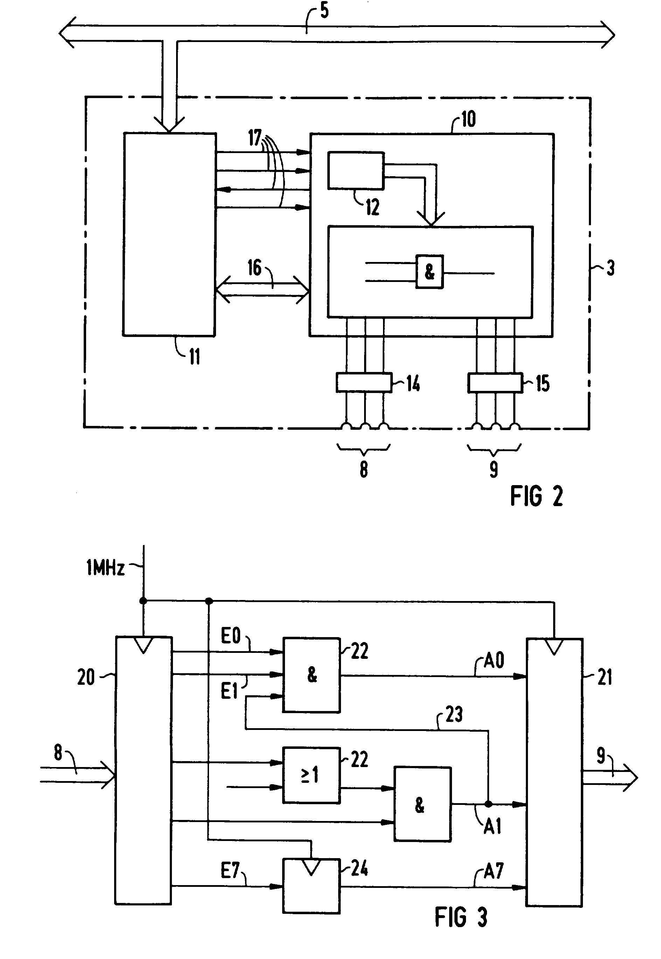

FIG 2 zeigt, in etwas geänderter Darstellung, den elektrischen Aufbau der Baugruppe 3. Wie aus FIG 2 ersichtlich ist, sind die Eingänge 8 mit dem Logikbaustein 10 über Eingangsfilter 14 und die Ausgänge 9 mit dem Logikbaustein 10 über Ausgangstreiber 15 verbunden. Dadurch wird erreicht, daß der Logikbaustein 10 bei einer versehentlichen Fehlverdrahtung bzw. bei einem Kurzschluß oder ähnlichen Fehlfunktionen nicht beschädigt wird. Weiterhin ist durch die Eingangsfilter 14 ein Entprellen der Eingangssignale möglich. Auch können über die Filter 14 und die Treiber 15 Signalpegelanpassungen vorgenommen werden, z.B. von 20mA auf 5 V.

Der Logikbaustein 10 ist über den Bus 16 sowie die Steuerleitungen 17 mit dem Prozessor 11 und damit auch mit dem Prozessor 6 verbunden. Dadurch wird es möglich, die korrekte Funktion des Logikbausteins 10 - auch während des Betriebs - zu überwachen. Zur Überwachung des Logikbausteins 10 können die Werte korrespondierender Eingänge 8 und Ausgänge 9 gleichzeitig zur Verarbeitung im Logikbaustein 10 an den Prozessor 11 und weiter an den Prozessor 6 übermittelt werden. Gegebenenfalls können auch Zwischenzustände des Logikbausteins 10, z. B. ein Merker oder ein Zählerstand, an den Prozessor 6 gemeldet werden. Es können auch neue Steuerungsparameter, z.B. neue Zeitkonstanten, an den Logikbaustein 10 übertragen werden.

Die in FIG 2 dargestellten Steuerleitungen 17 dienen beispielsweise der Übertragung eines Resetsignals, mit dem die internen Merker rücksetzbar sind, sowie der Meldung des Logikbausteins 10 an den Prozessor 6 über seinen derzeitigen Programmierzustand, also z.B. der Meldung "Programmierung Logikbaustein geändert". An dieser Stelle sei erwähnt, daß die Programmierung des Logikbausteins 10 nur dann geändert werden kann, wenn der Logikbaustein 10 inaktiv ist, d.h. wenn er nicht in die Steuerung eines Prozesses eingebunden ist. Wenn der Logikbaustein 10 aus mehreren unabhängig voneinander funktionsfähigen Teilen besteht, ist es auch möglich, daß nur der Teil, dessen Programmierung geändert wird, inaktiv ist.

Gemäß FIG 3 weist der Logikbaustein 10 ein Eingangslatch 20 und ein Ausgangslatch 21 auf, die beispielsweise mit einem Takt von 1 MHz getaktet sind. An die Eingänge des Eingangslatches 20 sind die Eingänge 8 angeschlossen. An die Ausgänge des Ausgangslatches 21 sind die Ausgänge 9 angeschlossen. Zwischen den Latches 20, 21 findet die eigentliche, parallele Verarbeitung der Signale statt. Hierzu wird beispielsweise im Logikschalter 22 eine elementare logische Verknüpfung der Eingänge E0 und E1 durchgeführt, gegebenenfalls auch mit Zwischenergebnissen, wie über die Leitung 23 angedeutet ist.

Das Ergebnis des Logikschalters 22 kann weiter verarbeitet werden oder auch direkt einem der Ausgänge zugeleitet werden, im gegebenen Fall dem Ausgang A0. Die Logikschalter 22 können, wie oben erwähnt, elementare logische Verknüpfungen durchführen, z.B. VERGLEICHEN, UND, ODER, NICHT-UND, NICHT-ODER. Um weitere, kompliziertere Funktionen realisieren zu können, ist es von Vorteil, wenn der Logikbaustein 10 speichernde Elemente 24 aufweist, aus denen dann z.B. Zähler, Zeitgeber oder Flankenmerker aufgebaut werden können.

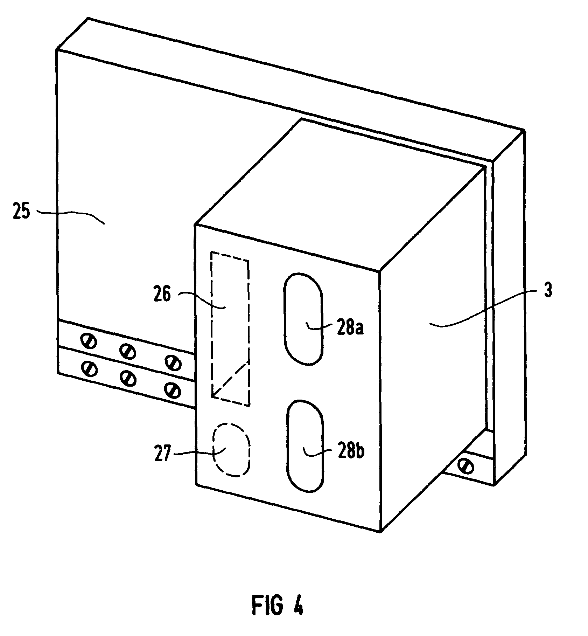

FIG 4 zeigt einen bevorzugten konstruktiven Aufbau der Ein-/Ausgabe-Baugruppe 3. Wie aus FIG 4 ersichtlich ist, ist die Baugruppe 3 eine gekapselte Flachbaugruppe, die mit einem modular aufgebauten Baugruppenträger 25 verbunden ist. Die Baugruppe 3 weist einen Schacht 26 für das z.B. in FIG 1 dargestellte Anwendermodul 13' und eine Schnittstelle 27 zum Anschluß eines Programmiergeräts auf. Über das Anwendermodul 13' und die Schnittstelle 27 ist es möglich, den in der Baugruppe 3 enthaltenen Logikbaustein 10 direkt, d.h. nicht über den Prozessor 6, zu programmieren.

Weiterhin weist die Baugruppe 3 zwei Sub-D-Steckkontakte 28a, 28b, wobei die Kontakte 28a zum Anschluß von Sensoren und die Kontakte 28b zum Anschluß von Stellgliedern dienen.

Die Kernidee der vorliegenden Erfindung ist es, ein herkömmliches, sequentielles Anwenderprogramm für eine speicherprogrammierbare Steuerung soweit wie möglich auf die aus der Schütztechnik bekannten Strukturen abzubilden, d.h. die korrespondierenden Ein- und Ausgänge über Logikelemente direkt zu verdrahten. Hierzu werden die logischen Bedingungen eines in einer Programmiersprache für speicherprogrammierbare Steuerungen erzeugten Anwenderprogrammes in eine Verbindungsliste konvertiert und in einem Datenfeld abgelegt. Diese Daten werden dann in den Logikbaustein 10 geladen und führen dort zu einer entsprechenden internen Verschaltung des Logikbausteins 10. Dabei ist es, wie in FIG 1 gezeigt, möglich, mehrere dieser Logikbausteine 10, 10' seriell und/oder parallel miteinander zu verschalten. Der Programmablauf wird dadurch auf die Zentraleinheit 2 und die Baugruppen 3,3' verteilt.

Durch die direkte Verdrahtung korrespondierender Ein- und Ausgänge miteinander entfällt für diese das bei konventionellen speicherprogrammierbaren Steuerungen benötigte Prozeßabbild. Weiterhin wird die speicherprogrammierbar Steuerung extrem schnell, die "Zykluszeit" geht tendenziell gegen Null. Auch wird das Alarmreaktionsverhalten reproduzierbarer, da die Alarmreaktionszeit besser eingehalten wird.

Im obenstehend beschriebenen Ausführungsbeispiel wurde der Logikbaustein in einem modular aufgebauten Automatisierungsgerät verwendet. Ebenso ist jedoch auch die Verwendung in einem allein betriebsfähigen Automatisierungsgerät möglich. In der Minimalversion dieses Automatisierungsgeräts weist das Automatisierungsgerät keinen Prozessor mehr, sondern nur noch den Logikbaustein auf, so daß das abzuarbeitende Programm vom Logikbaustein allein ausgeführt wird. Die Programmierung des Logikbausteins erfolgt in diesem Fall entweder über eine Schnittstelle zu einem Programmiergerät oder über ein Speichermodul, das vom Anwender programmiert wurde.

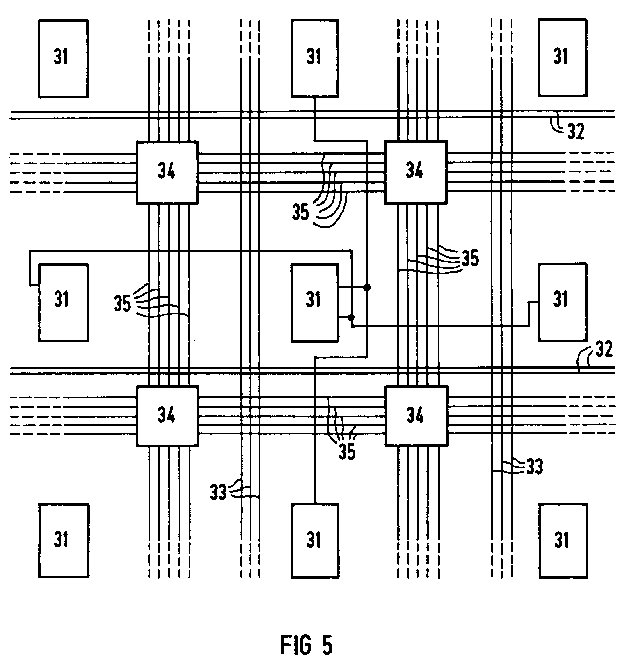

Die Logikbausteine 10, 10' sind im vorliegenden Fall umfeldprogrammierbare Logikfelder (FPGAs). Figur 5 zeigt einen Ausschnitt aus der inneren Struktur eines solchen Logikfeldes. Die innere Struktur weist eine zweidimensionale Matrix von z.B. 12 x 12 Logikblöcken 31 auf. Diese Matrix ist von einem Ring von Ein-/Ausgabe-Blöcken umgeben. Sowohl dem Anfang als auch dem Ende jeder (waagrechten) Reihe sind je zwei Ein-/Ausgabe-Blöcke zugeordnet. Gleiches gilt für die (senkrechten) Spalten. Die Ein-/Ausgabe-Blöcke sind der Übersichtlichkeit halber nicht dargestellt. Weiterhin sind jeder Reihe von Logikblöcken 31 je zwei nicht unterbrechbare Verbindungen 32 und jeder Spalte drei Verbindungen 33, von denen zwei einmal in der Mitte der Spalte unterbrochen werden können, zugeordnet. Diese Anordnung von Logikblöcken 31 und Ein-/Ausgabe-Blöcken ist durchsetzt von einem Netz mit 13 x 13 Schaltmatrizen 34, wobei benachbarte Schaltmatrizen 34 über je fünf Kurzverbindungen 35 miteinander verbunden sind.

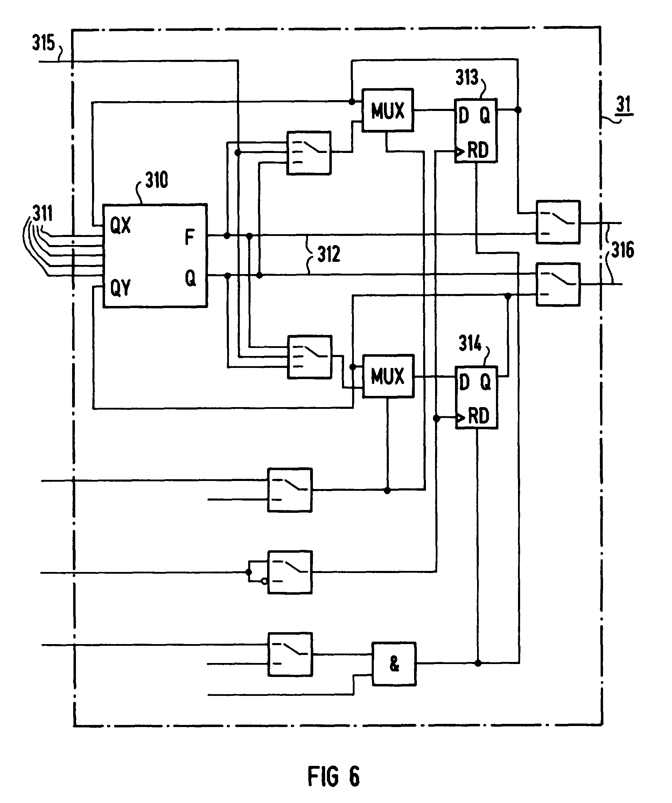

Die Logikblöcke 31 weisen gemaß Figur 6 einen Kombinatorikblock 310 auf, der aus maximal 5 Eingangsvariablen 311, zwei Ausgangsvariablen 312 ermittelt. Weiterhin weist der Logikblock 31 zwei Flipflops 313, 314 auf, deren Eingangssignal entweder aus einer der Ausgangsvariablen 312 des Kombinatorikblocks 310 oder aus einer direkt über den Eingang 315 eingegebenen Variable besteht. Die Ausgangssignale der Flipflops 313, 314 können entweder in den Kombinatorikblock 310 zurückgeführt werden oder aber als eines der Ausgangssignale 316 des Logikblocks 31 ausgegeben werden. Der Logikblock 31 ist also dahingehend programmierbar, welche logische und/oder Speicherfunktion er ausführen soll.

Die beiden Ausgangsfunktionen des Logikblockes 31 sind im Prinzip unabhängig voneinander, werden im vorliegenden Fall jedoch stets gleich gewählt, da jeder der beiden Ausgänge 316 mit je zwei der vier nächsten Nachbarn seines Logikbausteins direkt verbindbar ist. Dadurch, daß die beiden Funktionen identisch sind, wird also erreicht, daß das Ausgangssignal jedes Logikblocks 31 seinen vier nächsten Nachbarn als Eingangssignal zur Verfügung gestellt werden kann. Die Topologie wird folglich strukturierter.

Weiterhin können die Ausgänge 316 mit den sie umgebenden Kurzverbindungen 35 sowie den sie umgebenden Langverbindungen 32, 33 verbunden werden. Auch sind an den Kreuzungspunkten zwischen den Langverbindungen 32, 33 untereinander sowie zwischen den Langverbindungen 32, 33 und den Kurzverbindungen 35 noch elektrische Verbindungen programmierbar.

Die Schaltmatrizen 34 sind ebenfalls programmierbar. Sie können eine Vielzahl der theoretisch denkbaren Verschaltungsmöglichkeiten realisieren, z.B. waagrechte und/oder senkrechte Durchverbindungen, Kontaktieren von waagrechten mit senkrechten Kurzverbindungen 35 und Aufteilen von einer Verbindung auf zwei oder drei.

Die Ein-/Ausgabe-Blöcke sind jeweils mit einem Anschlußpin des Chips verbunden und können wahlweise entweder ein Signal eingeben oder ausgeben, wobei dieses Signal wahlweise getaktet werden kann oder nicht.

Die Programmierung der Logikblöcke 31, der Schaltmatrizen 34 und der Ein-/Ausgabe-Blöcke ist jeweils lokal in diesen Elementen gespeichert, die hierzu einen kleinen statischen Speicher (SRAM) aufweisen.

Bezüglich weiterer Einzelheiten über umfeldprogrammierbare Logikbausteine wird auf Herstellerhandbücher verwiesen, z.B. auf Handbücher über die XC 3000 Logic Cell Array Familie von Xilinx.

Zum Programmieren derartiger Logikfelder existieren ASIC-Design-Tools, mittels derer die Logikfelder in der Struktur des Logikfeldes angepaßten Stromlaufanweisungen programmierbar sind. Bei diesen Anweisungen muß der ASIC-Designer jedoch viele ASIC-spezifische Randbedingungen beachten. Solche Randbedingungen sind beispielsweise Gatterlaufzeiten, der Signalpegel von ungenutzten Gattereingängen usw. Es ist offensichtlich, daß eine derartige Programmierung hardwarenah und hochkomplex ist. Sie ist nur von ausgesprochenen Experten handhabbar.

Für das Umsetzen der gewünschten Programmierung in interne Verschaltungen des Logikbausteins 10 existieren Programme. Die Laufzeit dieser Programme, d.h. die Umsetzung des gewünschten Gesamtverhaltens in eine interne Verschaltung des Logikfeldes, beträgt, insbesondere wegen der vielfältigen Verbindungsmöglichkeiten, etliche Minuten, Stunden, manchmal sogar Tage.

Obenstehend erwähnte Spezialkenntnisse sind dem Anwender von speicherprogrammierbaren Steuerungen nicht zumutbar, ebensowenig die extrem langen Laufzeiten der Umsetzungsprogramme. Der SPS-Anwender erwartet Laufzeiten im Sekunden-, höchstens Minutenbereich. Im folgenden wird daher anhand eines Beispiels ein Verfahren beschrieben, mittels dessen ein in einer dem SPS-Anwender vertrauten Programmiersprache vorgegebenes Gesamtverhalten schnell und einfach in eine interne Verbindung des Logikfeldes umgesetzt werden kann.

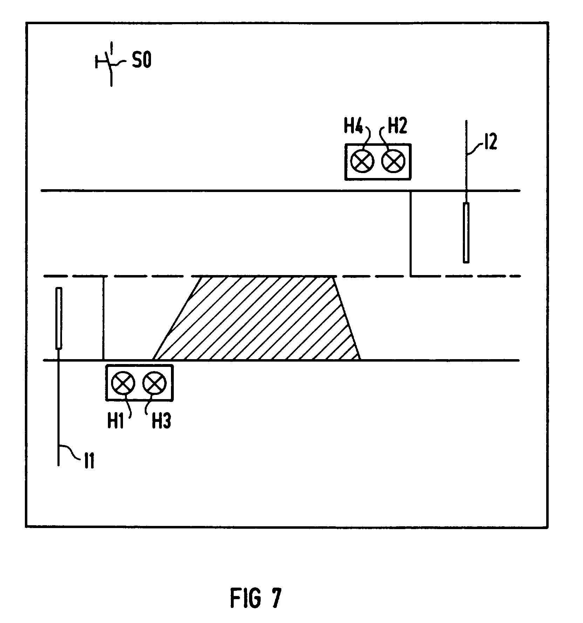

Das Beispiels ist der Aufgabensammlung Simatic S5 der Siemens AG, Bestell-Nr. E 80850-C 345-X-Al, entnommen und wird anhand von Figur 7 erläutert.

"Wegen Bauarbeiten muß der Verkehr auf einer Straße über eine Fahrspur geleitet werden. Da das Verkehrsaufkommen sehr hoch ist, wird eine Bedarfsampelanlage installiert. Beim Einschalten der Anlage zeigen beide Ampeln Rot. Wird ein Initiator betätigt, so schaltet die entsprechende Ampel nach 10 Sekunden auf Grün. Die Grünphase soll mindestens 20 Sekunden andauern, bevor durch eventuelle Betätigung des anderen Initiators beide Signallampen wieder Rot zeigen. Nach 10 Sekunden wird dann die andere Fahrspur mit Grün bedient. Liegt keine Meldung eines Initiators vor, so bleibt die Ampelanlage in ihrem jeweiligen Zustand. Das Ausschalten der Anlage soll nur nach der Grünphase einer Fahrspur möglich sein. Beim Einschalten der Steuerung muß der Grundzustand (M0) ohne Bedingung gesetzt werden."

Zur Umsetzung des Problems in eine SPS-Programmiersprache wird zunächst eine Umbenennung der Symbole vorgenommen wie in der untenstehenden Tabelle angegeben.

| Symbol | Operand | Kommentar |
|---|---|---|
| S0 | E0 | Schalter Ein (Schließer) |
| I1 | E1 | Initiator 1 (Schließer) |
| I2 | E2 | Initiator 2 (Schließer) |
| H1 | A1 | Grün |
| H2 | A2 | Grün |
| H3 | A3 | Rot |
| H4 | A4 | Rot |
| M0 | M0 | Grundzustand M0 |
| M1 | M1 | Zustand 1 |
| M2 | M2 | Zustand 2 |
| M3 | M3 | Zustand 3 |
| M4 | M4 | Zustand 4 |
| M5 | M5 | Zustand 5 |
| M6 | M6 | Zustand 6 |
| M7 | M7 | Zustand 7 |
| | T1 | Zeit 10 Sekunden |
| | T2 | Zeit 20 Sekunden |
| | KT 100.1 | Zeit für Zähler 1 |
| | KT 200.1 | Zeit für Zähler 2 |

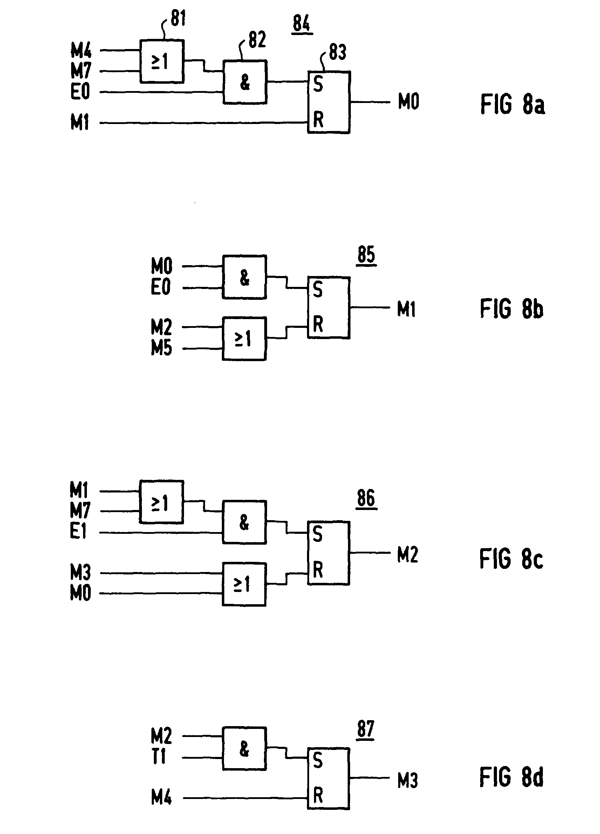

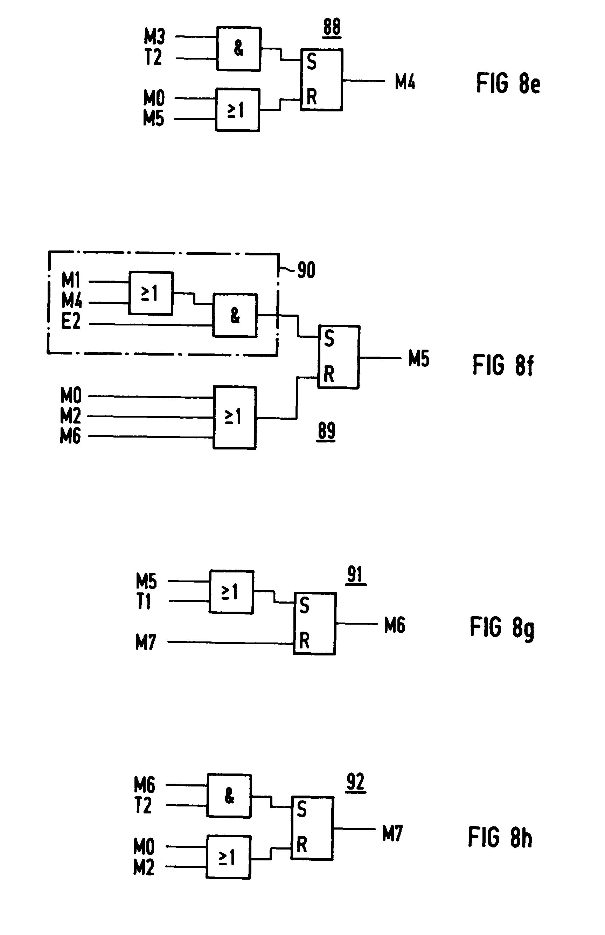

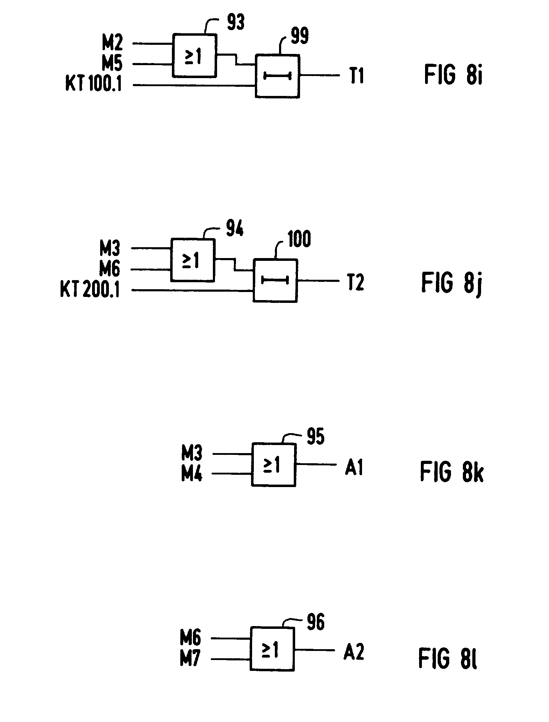

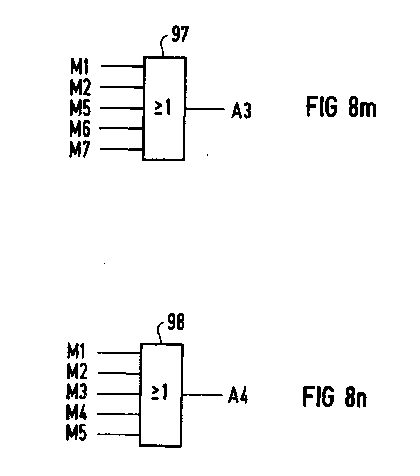

Die zugehörige Verschaltung stellt sich in der SPS-Programmiersprache FUP (= Funktionsplan) wie in FIG 8 gezeigt dar. Diese Art der Programmierung kennt der SPS-Anwender, und sie ist ihm geläufig. Die Aufgabe besteht darin, das vorgegebene, in einer SPS-Programmiersprache formulierte Gesamtverhalten schnell und einfach in eine FPGA-Struktur umzusetzen, so daß der SPS-Anwender im Ergebnis in die Lage versetzt wird, den Logikbaustein 10 selbst zu programmieren.

Erreicht wird dies dadurch, daß das Programm, das das SPS-Anwenderprogramm in die zugehörige interne Verschaltung des Logikbausteins 10 umsetzt, die theoretisch mögliche Komplexität des Logikbausteins 10 von vorneherein nur zu einem kleinen Bruchteil ausnützt. Dies geschieht dadurch, daß ein Teil der im Prinzip frei wählbaren Verbindungen, z.B. die interne Verschaltung der Schaltmatrizen 34, im Umsetzungsprogramm fest vorgegeben wird, also vom Ersteller des SPS-Anwenderprogramms nicht beeinflußbar ist. Konkret werden die Verschaltungen der Schaltmatrizen 34 jeder der dreizehn senkrechten Spalten derart vorgegeben, daß zum einen die oberste, die unterste sowie die mittleren drei der Schaltmatrizen 34 einer Spalte die waagerecht verlaufenden Kurzverbindungen 35 1:1 durchverbinden und die anderen der Kurzverbindungen 35 vorerst noch nicht verbinden und zum anderen die übrigen Schaltmatrizen 34 nur die senkrechten der Kurzverbindungen 35 1:1 durchverbinden und die waagrechten Kurzverbindungen 35 blockieren.

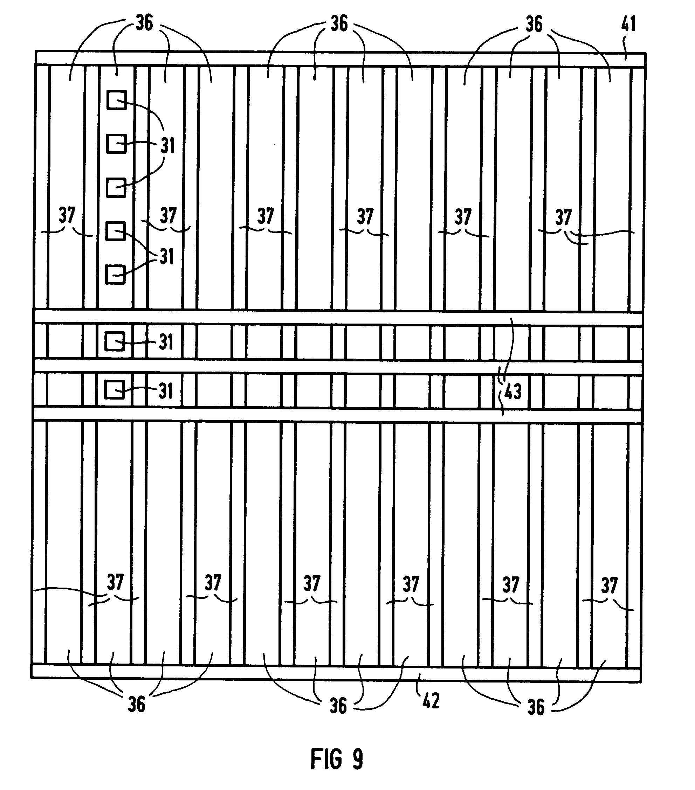

Es ergibt sich dadurch eine Struktur, wie sie in Figur 9 dargestellt ist: Es werden Gruppen 36 gebildet, die je fünf untereinander angeordnete Logikblöcke 31 enthalten und die vorne und hinten jeweils von fünf sich über die Länge einer "Halbspalte" erstreckenden Kurzverbindungen 37 umgeben sind. Auf diese Gruppen 36 wird die zu realisierende Schaltung von FIG 8 auf noch zu erläuternde Art und Weise abgebildet. Die beiden waagrechten mittleren Reihen von Logikblöcken 31 werden auf ebenfalls noch zu erläuternde Art und Weise zur Erzeugung von Taktsignalen genutzt.

Die so entstandenen Gruppen 36 weisen eine handliche Größe auf: Einerseits ist ihre Komplexität klein genug und daher überschaubar genug, um auf relativ einfache Art und Weise abschätzen zu können, ob ein Teilnetzwerk der zu realisierenden Gesamtschaltung durch eine der Gruppen 36 realisierbar ist, andererseits sind die Gruppen aber auch groß genug, um die Gesamtschaltung von FIG 8 nicht in zu kleine Teilnetzwerke zerstückeln zu müssen. Als Kriterium zur Auswahl der Teilnetzwerke dienen die zur Verfügung stehenden Verbindungsresourcen und die zur Verfügung stehende Logikkapazität der Gruppen 36. Jedes Teilnetzwerk wird derart bemessen, daß es folgende Kriterien erfüllt:
a) es weist maximal fünf Eingangssignale auf;
b) es weist maximal fünf Ausgangssignale auf;
c) es werden zur Realisierung des Teilnetzwerks maximal fünf der Logikblöcke 31 benötigt und
d) die Verdrahtung des Teilnetzwerks innerhalb der Gruppe 36 ist möglich.

Beginnend beim Oder-Gatter 81 in FIG 8 erkennt man sofort, daß auch das Und-Gatter 82 im selben Logikblock 31 realisierbar ist, da auch die Zusammenfassung dieser beiden Funktionen erst eine kombinatorische Funktion mit drei Eingängen und einem Ausgang ergibt. Dem RS-Flipflop 83 dagegen wird ein eigener Logikblock 31 zugewiesen, da jeder der Logikblöcke 31 aufgrund einer (willkürlichen) Compilervorschrift nur entweder eine kombinatorische Funktion ausführen oder eine Speicherfunktion wahrnehmen darf. Das Teilnetzwerk 84 kann folglich in einer Gruppe 36 realisiert werden, da insgesamt nur vier Eingangssignale, ein Ausgangssignal und zwei Logikblöcke 31 benötigt werden, die Kapazität einer Gruppe 36 also nicht überschritten wird.

Aufgrund ähnlicher Überlegungen ist leicht ersichtlich, daß auch die Teilnetzwerke 85 bis 88 in je einer Gruppe realisierbar sind. Vom nächsten Netzwerk 89 muß jedoch das Teilnetzwerk 90 abgetrennt werden, da sonst die Zahl der Eingänge den maximal zulässigen Wert von fünf überschritte.

Analog werden die anderen Netzwerke 91 bis 100 der Gesamtschaltung aufgeteilt, aber noch nicht bestimmten Gruppen 36 zugeordnet.

Eine gewisse Schwierigkeit bei der Aufteilung der einzelnen Netzwerke bereitet die Realisierung der Zeitglieder 99 und 100, da einem Zeitglied in der "SPS-Welt" kein entsprechendes Gegenstück in der "FPGA-Welt" gegenübersteht. Um dem SPS-Anwender dennoch die leichte Programmierung von Zeitgliedern zu ermöglichen, wird diese für speicherprogrammierbare Steuerungen (SPSen) oft benötigte Funktion dem Anwender als Funktionsmakro zur Verfügung gestellt.

Zur Compilerlaufzeit erkennt der Compiler, daß ein Funktionsmakro vorliegt und setzt diesen Makro in eine interne, innerhalb des Logikfeldes verschiebbare Standard-Verbindung um. Die interne Standard-Verbindung wurde dabei vorab vom Compilerhersteller bzw. vom ASIC-Designer bestimmt. Dadurch wird der Compiler nicht in nennenswertem Umfang mit der Ermittlung der Verbindungen belastet, die den Funktionsmakro realisieren.

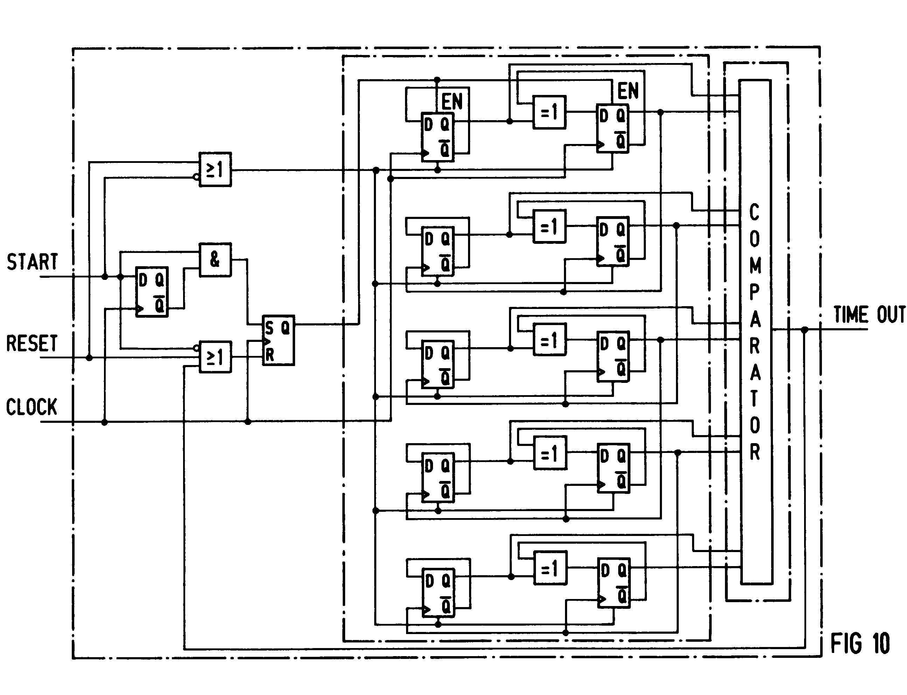

FIG 10 zeigt ein Beispiel einer solchen Standard-Verbindung für einen Zeitzähler, der bis zu 2¹⁰ Taktzyklen abzählen kann. Die tatsächlich zählbare Zeit ist selbstverständlich noch von der Taktung des Zählers abhängig.

Das in FIG 10 gezeigte Beispiel benötigt drei nebeneinanderliegende Gruppen 36 von Logikblöcken 31. Die genaue Abbildung der in FIG 10 dargestellten Logik auf FPGA-Strukturen ist dabei für den SPS-Anwender irrelevant. Bei der Erstellung derartiger Hardmakros, die mit Standard-ASIC-Design-Tools erfolgt, muß der Compiler-Hersteller bzw. der ASIC-Designer jedoch darauf achten, daß nur lokale Verbindungen, also direkte Verbindungen und Kurzverbindungen 35, verwendet werden, nicht aber globale Langverbindungen 32, 33. Hierdurch sind diese Makros nicht nur innerhalb des Logikfeldes leicht verschiebbar, also relocierbar. Sie sind auch unabhängig von den sie umgebenden Netzwerken oder Makros placierbar.

Da Hardmakros dem SPS-Programmierer (oder -Anwender) über eine Bibliothek zur Verfügung gestellt werden, die Makros also vorab erstellt worden sind, ist die interne Konfiguration eines solchen Makros auch nicht an die begrenzten Möglichkeiten der Anwenderprogrammierung gebunden, sondern es kann die volle Komplexität des beanspruchten Feldbereichs ausgenutzt werden. Die Restriktionen der Anwenderprogrammierung können entfallen.

Die Erstellung derartiger Hardmakros durch den Compiler-Hersteller bzw. den ASIC-Designer und auch der Lauf der Umsetzungsprogramme kann zwar Stunden oder sogar Tage dauern. Dies ist in diesem Fall aber möglich und tolerierbar. Zum einen sind nämlich nur 3 x 5 = 15 der Logikblöcke 31 statt 12 x 12 = 144 Logikblöcke 31 miteinander zu verschalten. Zum anderen werden die Makros, wie bereits erwähnt, vorab erstellt. Der Anwender wird folglich nicht mit der Erstellung dieser Makros belastet, sondern sie stehen ihm sofort zur Verfügung. Das Zuordnen des Hardmakros zu einer bestimmten Stelle im FPGA dauert aber nur Bruchteile von Sekunden. Beim Design des Hardmakros ist lediglich zu beachten, daß die vier Ein- bzw. Ausgänge "Start", "Reset", "Clock" und "Zeitablauf" leicht zugänglich sind.

Für andere mögliche Standard-Funktionen der "SPS-Welt" sind selbstverständlich gegebenenfalls auch größere oder kleinere dieser Hardmakros möglich.

Nach der Aufgliederung der Gesamtschaltung in Teilnetzwerke 84 bis 98 werden diese zusammengefaßt, soweit auch die Zusammenfassung die obenstehend beschriebenen Kriterien a) bis d) erfüllt. Es ergibt sich beispielsweise, daß die Teilnetzwerke 87 und 94 sowie die Teilnetzwerke 93 und 97 zusammenfaßbar sind. Dieser soeben beschriebene Schritt ist nicht unbedingt nötig, er erhöht aber den Ausnutzungsgrad des Logikfeldes.

Falls wider Erwarten im Einzelfall zur Realisierung der gewünschten Verschaltung die Zahl von fünf Eingängen bzw. fünf Ausgängen überschritten werden muß, kann dies dadurch realisiert werden, daß - je nach Bedarf - eine oder mehrere Gruppen 36 vor der Gruppe 36, die mehr als fünf Eingangssignale benötigt, freigelassen werden und diese Signale ausnahmsweise mittels der waagrechten Kurzverbindungen und/oder der direkten Verbindungen von Logikblöcken 31 der davorliegenden Gruppe 36 der Gruppe 36 zugeführt werden, die mehr als fünf Eingänge benötigt. Falls auch diese zusätzlichen Verbindungsmöglichkeiten nicht ausreichen, wird eine Fehlermeldung generiert "gewünschte Schaltung nicht generierbar, Verbindungsmöglichkeiten zu gering".

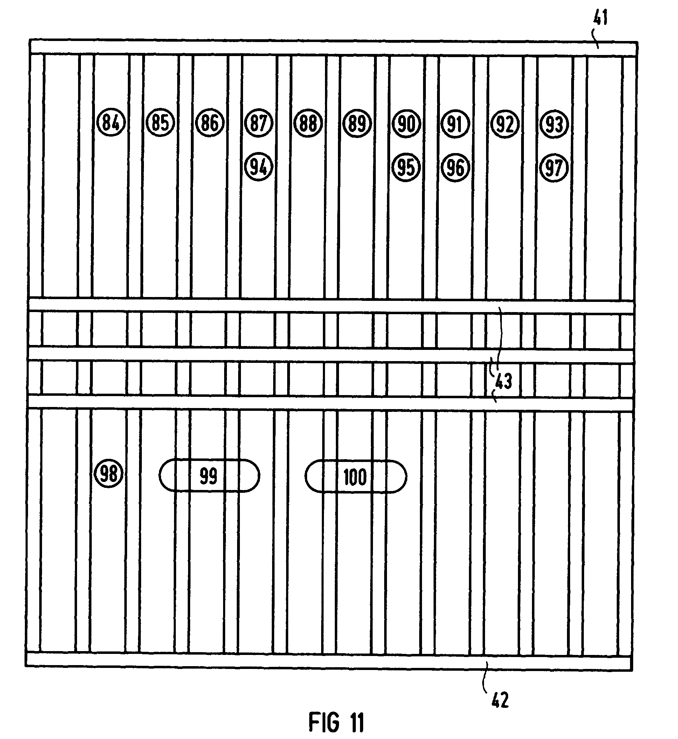

Die einzelnen Teilnetzwerke 84 bis 100 werden nunmehr den einzelnen Gruppen 36 zugeordnet so wie in Figur 11 dargestellt. An dieser Stelle sei erwähnt, daß die Zuordnung der Teilnetzwerke 84 bis 100 auf die einzelnen Gruppen 36 gemäß ihrer Reihenfolge vorgenommen wurde. Dies ist die einfachste Art und Weise, eine Zuordnung vorzunehmen; es sind aber auch komplexere Lösungen denkbar, die bereits die Verbindungen der Teilnetzwerke 84 bis 100 untereinander berücksichtigen. Die außenliegenden Gruppen 36 werden nicht belegt, da die außenliegenden verlängerten Kurzverbindungen 37 nicht zur Anbindung dieser Gruppen zur Verfügung stehen, sondern anderweitig benötigt werden. Diese anderweitige Verwendung wird später noch erläutert werden.

Ein Beispiel einer komplexeren Lösung bei der Zuordnung der Teilnetzwerke 84 bis 100 auf die einzelnen Gruppen 36 bestünde beispielsweise darin, das Netzwerk 98 in der äußersten rechten Gruppe 36 anzuordnen. Dieses Netzwerk hat nämlich als einzigen Ausgang den Prozeßausgang A4. Dieser Prozeßausgang aber könnte direkt auf einen Ein-/Ausgabe-Block gelegt werden. Es würden also weder verlängerte Kurzverbindungen 37 noch sonstige globale Verbindungsresourcen benötigt.

Nach der Zuordnung der Teilnetzwerke 84 bis 100 zu den Gruppen 36 werden die internen elektrischen Verbindungen festgelegt. Hierbei werden zunächst soweit als möglich die direkten Verbindungen zwischen den Logikblöcken 31 ausgenützt. Im vorliegenden Beispiel der Ampelschaltung sind dies nur wenige; zumeist läßt sich nur der Merkerausgang der Teilnetzwerke 84 bis 91 in das jeweils nächste Netzwerk weiterverbinden. Selbst dies ist im vorliegenden Fall aber nicht sinnvoll, da die Ausgangssignale der einzelnen Teilnetzwerke auch anderweitig benötigt werden und daher in jedem Fall auf globalere Verbindungen zurückgegriffen werden muß.

Als erstes werden die Ein- und Ausgangssignale vom und zum zu steuernden Prozeß verbunden, also die Eingangssignale E0 bis E2 und die Ausgangssignale A1 bis A4. Soweit möglich, werden die Ein- und Ausgangssignale direkt über die waagrechten Langverbindungen 32 den äußersten der verlängerten Kurzverbindungen 37 zugeführt. Falls die waagrechten Langverbindungen 32 bereits belegt sind, z.B. weil drei Signale anzuschließen sind, aber nur zwei waagrechte Langverbindungen 32 zur Verfügung stehen, werden die Signale zunächst auf senkrechte Langverbindungen 33 oder auf senkrechte Kurzverbindungen 37 gelegt. Dann werden sie über eine einer anderen Reihe von Logikblöcken 31 zugeordneten Langverbindung 32 an den Rand des Logikfeldes geführt. An den Rändern des Logikfeldes werden die Ein- und Ausgangssignale mittels der verlängerten Kurzverbindungen 37 derart weiterverbunden, daß z.B. das logische Eingangssignal E0 an den physikalischen Prozeßeingang E0 angeschlossen ist.

Durch einfaches Abzählen der verbleibenden internen Ein- bzw. Ausgänge der einzelnen Netzwerke 84 bis 100 ergibt sich sodann, daß ausnahmslos stets die fünf verlängerten Kurzverbindungen 37 zwischen den Teilnetzwerken 84 bis 100 ausreichen, um die Ein-und Ausgänge der Teilnetzwerke 84 bis 100 senkrecht miteinander zu vernetzen. Falls im Einzelfall mehr als fünf Leitungen benötigt werden würden, würde zur vollständigen Verbindung auf die senkrechten Langverbindungen 33 zurückgegriffen werden, vorzugsweise zunächst auf die unterbrechbaren der Langverbindungen 33.

Durch ebensolches einfaches Abzählen ergibt sich weiterhin, daß nunmehr nur noch dreizehn verschiedene Signale innerhalb des Logikfeldes geführt werden müssen, nämlich die acht Merkersignale M0 bis M7, die zwei Timer-Signale T1 und T2 sowie 3, interne Signale vom Teilnetzwerk 90 zum Teilnetzwerk 89, vom Teilnetzwerk 93 zum Teilnetzwerk 99 und vom Teilnetzwerk 94 zum Teilnetzwerk 100.

Nunmehr ist jedoch offensichtlich, daß diese interne Verbindung leicht möglich ist. Es werden nämlich einfach nacheinander die internen Ausgangssignale in der Reihenfolge ihres Entstehens auf die beiden äußeren der drei mittleren Kurzverbindungsleisten 43 gelegt. Hierdurch sind zehn interne Signale innerhalb des gesamten Logikfeldes abgreifbar. Sie stehen damit überall als interne Eingangssignale zur Verfügung.

Die drei noch zu verbindenden internen Ausgangssignale werden auf drei der waagrechten Langverbindungen 32 gelegt, so daß sie ebenfalls abgegriffen werden können, wo sie benötigt werden. Falls eines dieser drei Signale in der oberen Reihe der Gruppen 36 als Ausgangssignal anfällt, jedoch in der unteren Reihe von Gruppen 36 benötigt wird, wird dieses Problem wie folgt gelöst: Das jeweilige interne Ausgangssignal wird auf eine der waagrechten Langverbindungen 32 in der oberen Hälfte des Logikfeldes gelegt, diese waagrechte Langverbindung 32 mit einer senkrechten Langverbindung 33 verbunden und die senkrechte Langverbindung 33 mit einer waagrechten Langverbindung 32 verbunden, die in der unteren Hälfte des Logikfeldes angeordnet ist. Hierdurch steht dieses Signal auch in der unteren Hälfte des Logikfeldes zur Verfügung.

In analoger Weise wird selbstverständlich verfahren, wenn ein internes Signal in der unteren Hälfte des Logikfeldes erzeugt, jedoch in der oberen Hälfte als Eingangssignal benötigt wird.

Darüber hinaus lassen sich bei vorausschauender Anordnung der Netzwerke 84 bis 100 innerhalb des Logikfeldes drei der internen Signale direkt verbinden, so daß für die dann noch verbleibenden zehn internen Signale die beiden äußeren der Kurzverbindungsleisten 43 ausreichen.

Die oben stehend erwähnten drei internen Signale fallen nämlich jeweils nur einmal als Ausgangssignal an, nämlich in den Teilnetzwerken 90, 93 und 94, und werden auch nur einmal als Eingangssignale benötigt, nämlich von den Teilnetzwerken 89, 99 und 100. Wenn also die Teil netzwerke 90 und 89, 93 und 99 sowie 94 und 100 jeweils unmittelbar hintereinander abgeordnet werden, können diese Signale direkt über Nächste-Nachbar-Verbindungen der Logikblöcke 31 untereinander verbunden werden. Auch ist eine Verbindung über die zwischen den jeweiligen Teilnetzwerkpaaren liegende verlängerte Kurzverbindung 37 möglich. In beiden Fällen werden keine waagrechten Verbindungen 32, 41, 42, 43 benötigt. Diese Verbindungen stehen damit anderweitig zur Verfügung.

Für die Taktung der Zeitzähler 99, 100 werden innerhalb des Logikfeldes Systemtakte von 1 ms, 10 ms, 100 ms und 1 sec. bereitgestellt. Dies geschieht auf folgende Art und Weise:

Mittels ASIC-Design-Tools werden hierzu vom Compiler-Hersteller vorab Teilerstufen erstellt, die einen beliebigen, von außen eingekoppelten Systemtakt auf ein 1/10, 1/100 und 1/1000 seiner ursprünglichen Frequenz herunterteilen. Dieser Makro, im folgenden Teilermakro genannt, wird dabei derart erstellt, daß er nur die beiden mittleren, bisher ungenutzen Reihen von Logikblöcken 31 sowie die direkten Verbindungen zwischen diesen Logikblöcken benötigt. Dieser Teil der (System-) Programmierung des FPGAs steht fest und ändert sich nicht. Von außerhalb des Logikbausteins 10 wird über einen der Ein-Ausgabe-Puffer ein Takt von 1 ms direkt in diesen Teilermakro eingekoppelt.

Die vier FPGA-internen Systemtakte von 1, 10, 100 und 1000 ms werden beispielsweise je einer der vier waagrechten Langverbindungen 32 zugeteilt, die den beiden mittleren Reihen von Logikblöcken 31 zugeordnet sind. Diese vier Zeittakte stehen damit im ganzen Logikfeld bereit und können dementsprechend abgegriffen werden. Welcher der Systemtakte an die Zeitzähler 99, 100 angeschlossen wird, ergibt sich für den Compiler aus der Bezeichnung der Eingangsvariablen KT x.y. x bezeichnet nach allgemeiner Regelung die Zahl der zu zählenden Taktzyklen und y ist ein Code für die Zeiteinheit. 200.1 bedeutet also beispielsweise, daß 200 Zyklen des Taktes mit dem Code 1, d.h. 100 ms, zu zählen sind. Im Ergebnis mißt der Zeitzähler 100 also 200 x 100 ms = 20 sec.

Zum ordnungsgemäßen Ablauf des Steuerungsprogramms müssen im Regelfall die Logikbausteine 10, 10' und die Zentraleinheit 2 auch während des Betriebs Daten miteinander austauschen. Es kann beispielsweise sein, daß die Parametrierung des Logikbausteins 10 während des Betriebs geändert werden soll. Weiterhin sollte die Zentraleinheit 2 zumindest zeitweise über den aktuellen Zustand des Logikbausteins 10 (bzw. 10') informiert werden. Der Prozessor 6 und die Logikbausteine 10, 10' sind jedoch nicht miteinander synchronisiert. Es stellt sich daher das Problem der Datenkonsistenz. Das Problem wird dadurch noch vergrößert, daß der Datenverkehr zwischen Prozessor 6 und Logikbausteinen 10, 10' seriell verläuft. Der serielle Datenverkehr ist nötig, da ansonsten zu viele Pins der Logikbausteine 10, 10' für den Datenverkehr mit dem Prozessor 6 benötigt würden.

Das Problem wird dadurch gelöst, daß dem Anwender weitere Funktionsmakros zur Verfügung gestellt werden. Diese Funktionsmakros realisieren Schieberegister, die der Zwischenspeicherung von Ein- oder Ausgabedaten dienen, sowie Arbeitsspeicher. Dabei werden zunächst die neu einzugebenden Daten vom Prozessor 6 in die Schreibzwischenspeicher z.B. des Logikbausteins 10 eingeschrieben. Während dieser Zeit sind die in den Zwischenspeichern abgespeicherten Werte zwar im Logikbaustein 10 vorhanden, werden aber vorerst nicht verwendet, da sie vorerst noch nicht freigegeben wurden. Mittels eines eigenen Befehls werden sodann die neu in den Logikbaustein 10 eingeschriebenen Werte von den Zwischenspeichern in die Arbeitsspeicher übernommen. Gleichzeitig werden die aus dem Logikbaustein 10 auszulesenden Werte in andere, sogenannte Lesezwischenspeicher eingelesen. Sodann werden die Daten seriell aus diesen Lesezwischenspeichern in den Prozessor 6 ausgelesen.

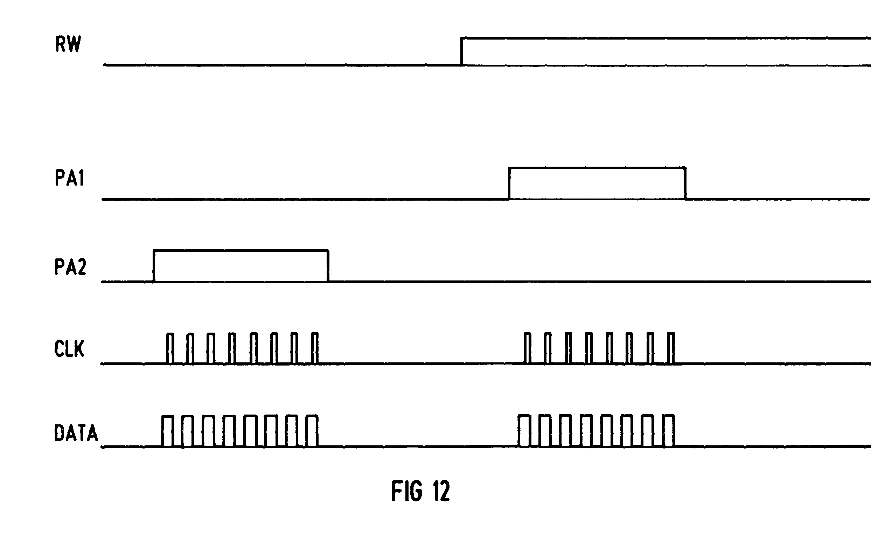

FIG 12 zeigt ein Beispiel eines solchen Datenzyklus. Im vorliegenden Fall werden zum Übertragen aller benötigten Signale fünf Leitungen benötigt. Dabei werden auf den Leitungen folgende Informationen übertragen:

Solange der Signalpegel der Leitung RW Null ist, können Daten in die Schreibzwischenspeicher geschrieben werden. Solange der Signalpegel der Leitung RW 1 ist, können Daten aus den Lesezwischenspeichern gelesen werden. Alle Zwischenspeicher sind derart an die Leitung RW angeschlossen, daß sie auf die ansteigende Signalflanke der Leitung RW getriggert sind. Zum Triggerzeitpunkt werden zum einen die Daten aus den Schreibzwischenspeichern in die Arbeitsspeicher übernommen. Zum anderen werden Daten aus den Logikblöcken 31 in die dafür vorgesehenen Lesezwischenspeicher übernommen.

Die Signale PA1 und PA2 sind Adreßsignale. Mittels der Adreßsignale PA1 und PA2 können maximal je drei Schreibzwischenspeicher und Lesezwischenspeicher adressiert werden. Der theoretisch mögliche vierte Speicher (2 Signale = 2 = 4 Adressierungsmöglichkeiten) darf nicht verwendet werden. Diese Pegel werden nämlich an den Logikbaustein 10 angelegt, wenn keine Daten eingelesen bzw. ausgelesen werden. Daher darf diese Adresse, z.B. die Doppelnull, nicht verwendet werden.

CLK ist ein Takt. Wenn CLK Eins ist, liest der jeweils angesprochene Zwischenspeicher ein neues Bit ein bzw. aus.

Data ist die Datenleitung, auf der die Information selbst übertragen wird. Im vorliegenden Beispiel werden (rein zufällig) lauter Einsen übertragen.

Es ergibt sich aufgrund einfacher Überlegung, daß zum Lesen bzw. Schreiben der Zwischenspeicher mindestens vier Leitungen benötigt werden, nämlich die Leitungen RW, CLK, Data sowie mindestens eine Adreßleitung. Diese vier Signale werden auf die mittlere, bisher ungenutzte der drei Kurzverbindungsleisten 43 gelegt. Dadurch stehen diese vier Signale quer über den gesamten Logikbaustein 10 zu Verfügung. Falls überhaupt keine Parameter ein- und auszulesen sind, steht auch die mittlere der drei Kurzverbindungsleisten 43 für die interne Verbindung der Gruppen 36 zur Verfügung.

Falls mehr als drei Lesezwischenspeicher bzw. Schreibzwischenspeicher zu adressieren sind, werden weitere Adreßsignale PA3, PA4 etc. an den Logikbaustein 10 angelegt. Diese zusätzlichen Adreßsignale werden im Regelfall auf zwei waagrechte Langverbindungen 32 gelegt, wobei die eine der Langverbindungen 32 in der oberen Hälfte des Logikfeldes und die andere in der unteren Hälfte des Logikfeldes angeordnet ist.

Es bedarf keiner Erwähnung, daß die Bildung von zusätzlichen Speichermakros Logikfeldkapazitäten beansprucht. Diese Logikfeldkapazitäten stehen selbstverständlich anderweitig nicht mehr zur Verfügung.

Die obenerwähnten Speichermakros sind, ebenso wie die Timer, vorab vom Compilerhersteller mit ASIC-Design-Tools erstellt worden. Dem Compilerhersteller ist dabei im Rahmen seines allgemeinen Fachwissens bekannt, wie Register und Schieberegister aufzubauen sind. Ebenso ist in der Elektronik allgemein bekannt, wie Schieberegister mittels Adreßleitungen anzusteuern sind, so daß nur jeweils eines angesprochen wird. Derartige Speicherkonfigurationen bedürfen daher im Rahmen der vorliegenden Erfindung keiner weiteren Erläuterung.

Damit sind nun alle wesentlichen Schritte zur schnellen und einfachen Umsetzung eines SPS-Programms in eine FPGA-Struktur bekannt. Die nunmehr bekannten internen elektrischen Verbindungen und die nunmehr ebenfalls ermittelte Programmierung der einzelnen Logikblöcke 31 werden in an sich bekannter Weise dem Logikfeld eingeprägt, so daß es also das gewünschte Gesamtverhalten, hier die Ampelsteuerung, realisiert. Weiterhin erhält der Anwender eine Meldung über den Ausnutzungsgrad des Logikfeldes oder, falls die Realisierung nicht möglich ist, eine diesbezügliche Meldung sowie eine Information darüber, warum die Realisierung nicht möglich war, z.B. weil keine Verbindungsreserven mehr zur Verfügung standen.

Die im vorliegenden Fall als Ausführungsbeispiel gewählte Ampelsteuerung ist selbstverständlich nicht so zeitkritisch wie andere Steuerungsvorgänge. Sie wurde jedoch gewählt, da sich anhand dieses einfachen Beispiels die prinzipielle Vorgehensweise einfach erläutern läßt.

Im Ergebnis ergibt sich damit ein umfeldprogrammierbares Logikfeld, das zwar bei weitem nicht optimal ausgenutzt ist, dessen Programmierung aber schnell und einfach und vor allem in einer dem SPS-Anwender vertrauten Art und Weise erfolgt.

## Patentansprüche

1. Speicherprogrammierbare Steuerung, insbesondere für Verpackungs- und Etikettiermaschinen, mit mehreren Prozeßein-(8) und -ausgängen (9) zum Anschließen von Prozeßführungselementen, z.B. Sensoren oder Stellgliedern,
- wobei die speicherprogrammierbare Steuerung mindestens ein umfeldprogrammierbares Logikfeld (10) mit Logikfeldein- und Logikfeldausgängen und einer zwischen den Logikfeldein- und den Logikfeldausgängen angeordneten internen Verschaltung aufweist,
- wobei mindestens einer der Prozeßeingänge (8) mit einem der Logikfeldeingänge und mindestens einer der Prozeßausgänge (9) mit einem der Logikfeldausgänge verbunden ist,
- wobei die interne Verschaltung den mindestens einen Prozeßausgang (9) mit seinem korrespondierenden Prozeßeingang (8) verbindet,
**dadurch gekennzeichnet,**
- daß das Logikfeld (10) eine zweidimensionale Matrix von Logikblöcken (31) aufweist, die von einem Ring von Ein-/Ausgabeblöcken umgeben ist, und
- daß die Matrix von Logikblöcken (31) zuzüglich des Rings von Ein-/Ausgabeblöcken von einem Netz programmierbarer Verbindungen durchsetzt ist.

2. Steuerung nach Anspruch 1, **dadurch gekennzeichnet**, daß die interne Verschaltung des umfeldprogrammierbaren Logikfeldes (10) reprogrammierbar ist.

3. Steuerung nach Anspruch 1 oder 2, **dadurch gekennzeichnet**, daß das umfeldprogrammierbare Logikfeld (10) einen - vorzugsweise statischen - Speicher (12) zum Speichern der Bedingungen aufweist, die seine interne Verschaltung festlegen.

4. Steuerung nach einem der obigen Ansprüche, **dadurch gekennzeichnet**, daß sie mindestens einen Anwenderspeicher (13') aufweist, der die interne Verschaltung des umfeldprogrammierbaren Logikfeldes (10') festlegt.

5. Steuerung nach einem der obigen Ansprüche, **dadurch gekennzeichnet**, daß das umfeldprogrammierbare Logikfeld (10) mindestens einen Anschluß (17) für ein Taktsignal aufweist.

6. Steuerung nach einem der obigen Ansprüche, **dadurch gekennzeichnet**, daß der Prozeßeingang (8) über einen Eingangsfilter (14) und der Prozeßausgang (9) über einen Ausgangstreiber (15) mit dem umfeldprogrammierbaren Logikfeld (10) verbunden ist.

7. Steuerung nach einem der obigen Ansprüche, **dadurch gekennzeichnet**, daß sie modular aufgebaut ist und das umfeldprogrammierbare Logikfeld (10) in einer Ein-/Ausgabe-Baugruppe (3) angeordnet ist.

8. Steuerung nach Anspruch 4 und 7, **dadurch gekennzeichnet**, daß die Ein-/Ausgabe-Baugruppe (3) einen Steckplatz (26) für den Anwenderspeicher (13') aufweist.

9. Steuerung nach Anspruch 7 oder 8, **dadurch gekennzeichnet**, daß die Baugruppe (3) eine Schnittstelle (27) zum Anschluß eines Daten-Ein-/Ausgabegeräts, z.B. eines Programmiergeräts, aufweist.

10. Steuerung nach Anspruch 7, 8 oder 9, **dadurch gekennzeichnet**, daß die Baugruppe mehrpolige Steckkontakte (28a, 28b) zum Anschließen der Prozeßführungselemente aufweist.

## Claims

1. Programmable controller, in particular for packaging and labelling machines, having several process inputs (8) and outputs (9) for connecting process control elements, for example sensors or final controlling elements,
- the programmable controller having at least one field-programmable logic array (10) with logic array inputs and logic array outputs and an internal circuit configuration arranged between the logic array inputs and logic array outputs,
- at least one of the process inputs (8) being connected to one of the logic array inputs and at least one of the process outputs (9) being connected to one of the logic array outputs,
- the internal circuit configuration connecting at least one process output (9) to its corresponding process input (8),
**characterised in that**
- the logic array (10) has a two-dimensional matrix of logic blocks (31) which is surrounded by a ring of input/output blocks, and
- the matrix of logic blocks (31), plus the ring of input/output blocks, is permeated by a network of programmable connections.

2. Controller according to Claim 1, characterised in that the internal circuit configuration of the field-programmable logic array (10) can be reprogrammed.

3. Controller according to Claim 1 or 2, characterised in that the field-programmable logic array (10) has a - preferably static - memory (12) to store the conditions which determine its internal circuit configuration.

4. Controller according to one of the above Claims, characterised in that it has at least one user memory (13') which determines the internal circuit configuration of the field-programmable logic array (10').

5. Controller according to one of the above Claims, characterised in that the field-programmable logic array (10) has at least one connection (17) for a clock signal.

6. Controller according to one of the above Claims, characterised in that the process input (8) is connected to the field-programmable logic array (10) via an input filter (14) and the process output (9) is connected to the field-programmable logic array (10) via an output driver (15).

7. Controller according to one of the above Claims, characterised in that it is of modular construction and the field-programmable logic array (10) is arranged in an input/output module (3).

8. Controller according to Claim 4 and 7, characterised in that the input/output module (3) has a slot (26) for the user memory (13').

9. Controller according to Claim 7 or 8, characterised in that the module (3) has an interface (27) for connection of a data input/output device, for example a programming device.

10. Controller according to Claim 7, 8 or 9, characterised in that the module has multi-pole plug contacts (28a, 28b) for connecting the process control elements.

## Revendications

1. Automate programmable industriel, notamment pour des machines d'emballage et d'étiquetage, comportant plusieurs entrées (8) et sorties (9) de processus destinées aux raccordements d'éléments de conduite du processus, par exemple de capteurs ou d'organes de réglage,
- la commande par programme enregistré comportant au moins un réseau logique (10) programmable de l'extérieur, qui comprend des entrées et sorties de réseau logique et un câblage interne entre les entrées et les sorties de réseau logique,
- au moins l'une des entrées (8) du processus étant reliée à l'une des entrées de réseau logique et au moins l'une des sorties (9) de processus étant reliée à l'une des sorties de réseau logique,
- le câblage interne reliant la au moins une sortie (9) de processus à son entrée (8) de processus correspondante,
caractérisée en ce que
- le réseau logique (10) comporte une matrice bidimensionnelle de blocs (31) logiques, qui sont entourés d'un anneau de blocs d'entrée/sortie, et
- la matrice de blocs (31) logiques y compris l'anneau de blocs d'entrée/sortie est traversée par un réseau de connexions programmables.

2. Automate suivant la revendication 1,
caractérisé en ce que le câblage interne du réseau logique (10) programmable de l'extérieur peut être reprogrammé.

3. Automate suivant la revendication 1 ou 2,
caractérisée en ce que le réseau logique (10) programmable de l'extérieur comporte une mémoire (12), de préférence statique, destinée à la mémorisation des conditions, qui fixent son câblage interne.

4. Automate suivant l'une des revendications ci-dessus,
caractérisée en ce qu'elle comporte au moins une mémoire (13') d'utilisateur, qui fixe le câblage interne du réseau logique (10') programmable de l'extérieur.

5. Automate suivant l'une des revendications ci-dessus,
caractérisée en ce que le réseau logique (10) programmable de l'extérieur comporte au moins un raccordement (17) pour un signal de cadence.

6. Automate suivant l'une des revendications ci-dessus,
caractérisée en ce que l'entrée (8) de processus est reliée au réseau logique (10) programmable de l'extérieur par l'intermédiaire d'un filtre (14) d'entrée et la sortie (9) de processus est reliée au réseau logique (10) programmable de l'extérieur par l'intermédiaire d'un étage (15) d'attaque de sortie.

7. Automate suivant l'une des revendications ci-dessus,
caractérisée en ce qu'elle a une structure modulaire et le réseau logique programmable (10) de l'extérieur est disposé dans un module (3) d'entrée/sortie.

8. Automate suivant les revendications 4 et 7,
caractérisée en ce que le module (3) d'entrée/sortie comporte un emplacement (26) d'enfichage pour la mémoire (13') d'utilisateur.

9. Automate suivant la revendication 7 ou 8,
caractérisée en ce que le module (3) comporte une interface (27) destinée au raccordement d'un appareil d'entrée/sortie de données, par exemple d'un appareil de programmation.

10. Automate suivant la revendication 7, 8 ou 9,
caractérisée en ce que le module comporte des contacts (28a, 28b) d'enfichage multipolaires destinés aux raccordements des éléments de conduite du processus.
